# EUROPEAN PATENT APPLICATION

(11) **EP 4 815 360 A1**
(43) Date of publication of application: **30.09.2026**
(21) Application number: 25224114.6
(22) Date of filing: 16.12.2025
(51) Int. Cl.: H04L 7/00, G06F 1/06, H03K 5/135, H03M 9/00, H04L 25/14

(54) **PHASE ERROR MONITOR**

(30) Priority: 28.03.2025 US 202519094594
(71) Applicant: INTEL Corporation, Santa Clara, CA 95054 (US)
(72) Inventor: O'MAHONY, Frank, Portland, 97129 (US); BALANKUTTY, Ajay, Portland, 97229 (US); YU, Kai, Portland, 97229 (US); KIM, Jihwan, Portland, 97229 (US); KUNDU, Sandipan, Hillsboro, 97124 (US); TOROKER, Zeev, 2630814 Haifa (IL)
(74) Representative: HGF

(57) **Abstract**

An apparatus (e.g., a phase error monitor) includes a slicer circuit, a data delay circuit, a multiplier circuit, and an alignment detector circuit. The slicer circuit includes a first input terminal coupled to a transmitter (Tx) output network circuit. The data delay circuit includes an input terminal to receive transmit data. The multiplier circuit includes a first input terminal coupled to an output terminal of the slicer circuit, and a second input terminal coupled to an output terminal of the data delay circuit. The alignment detector circuit includes an input terminal coupled to an output terminal of the multiplier circuit.

## Description

### BACKGROUND

Phase spacing errors (manifesting as Even-Odd Jitter, EOJ, for example) in transmit (Tx) architectures reflect the phase accuracy of the multi-phase clocks used to generate the serialized Tx data output. Reducing the serializer-deserializer (SerDes) phase spacing errors in transmitter architectures can be challenging, especially with SerDes circuits using multi-phase clocks, where the timing requirements tighten inversely proportional to the baud rate of the transmitter physical layer (PHY).

### BRIEF DESCRIPTION OF THE DRAWINGS

In the drawings, like numerals may describe the same or similar components or features in different views. Like numerals having different letter suffixes may represent different instances of similar components. Some embodiments are illustrated by way of example, and not limitation, in the figures of the accompanying drawings listed below.
FIG. 1 is a block diagram of a transmitter architecture using clock phase sensing by multiplexers.
FIG. 2 is a block diagram of a transmitter architecture using a slice replica for clock phase sensing.
FIG. 3 is a simplified block diagram of a phase error monitor, in accordance with some embodiments.
FIG. 4 is a block diagram of a transmitter with a phase error monitor and an N:1 multiplexed driver, in accordance with some embodiments.
FIG. 5 is a detailed block diagram of a transmitter with a phase error monitor and a 4:1 multiplexed driver, in accordance with some embodiments.
FIG. 6 is a measurement results graph of silicon results for the symbol identification stage, in accordance with some embodiments.
FIG. 7 is a simulation results graph of behavioral model (BMOD) simulation results for the symbol identification stage, in accordance with some embodiments.
FIG. 8 is a simulation results graph of a sampling clock position at the current symbol identification stage, in accordance with some embodiments.
FIG. 9 is a simulation results graph of error monitor (EM) clock delay movement toward the data edge, in accordance with some embodiments.
FIG. 10 is a simulation results graph of the EM sampling clock at the data edge, in accordance with some embodiments.
FIG. 11 is a simulation results graph of fixing duty cycle Q skew, in accordance with some embodiments.
FIG. 12 is a simulation results graph of fixing duty cycle I skew, in accordance with some embodiments.
FIG. 13 is a simulation results graph of fixing skew between clock I and clock Q, in accordance with some embodiments.
FIG. 14 is a simulation results graph of the duty cycle error of clock 0 (C0), in accordance with some embodiments.
FIG. 15 is a measurement results graph of the error filter value when there is a clock I duty cycle skew, in accordance with some embodiments.
FIG. 16 is a simulation results graph of the duty cycle error of clock 90 (C90), in accordance with some embodiments.
FIG. 17 is a measurement results graph of the error filter value when there is a clock Q duty cycle skew, in accordance with some embodiments.
FIG. 18 is a simulation results graph of quadrature error between clock 0 (C0) and clock 90 (C90), in accordance with some embodiments.
FIG. 19 is a measurement results graph of the error filter value when there is a clock I/Q skew, in accordance with some embodiments.
FIG. 20 is a simulation results graph of the EM clock skew, in accordance with some embodiments.
FIG. 21 is a flow diagram of an example process of making a phase error monitor, in accordance with some embodiments.
FIG. 22 illustrates a block diagram of an example machine upon which any one or more of the operations/techniques (e.g., methodologies) discussed herein may perform.

### DETAILED DESCRIPTION

The following detailed description refers to the accompanying drawings. The same reference numbers may be used in different drawings to identify the same or similar elements. In the following description, for purposes of explanation and not limitation, specific details are set forth, such as particular structures, architectures, interfaces, techniques, etc., to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail.

The following description and the drawings sufficiently illustrate specific embodiments to enable those skilled in the art to practice them. Other embodiments may incorporate structural, logical, electrical, process, and other changes. Portions and features of some embodiments may be included in or substituted for those of other embodiments. Embodiments outlined in the claims encompass all available equivalents of those claims.

As used herein, the term "chip" (or die) refers to a piece of a material, such as a semiconductor material, that includes a circuit, such as an integrated circuit or a part of an integrated circuit. The term "memory IP" indicates memory intellectual property. The terms "memory IP," "memory device," "memory chip," and "memory" are interchangeable.

The term "a processor" configured to carry out specific operations includes both a single processor configured to carry out all of the operations (e.g., operations or methods disclosed herein) as well as multiple processors individually configured to carry out some or all of the operations (which may overlap) such that the combination of processors carry out all of the operations.

As used herein, the term "IO" indicates input/output. As used herein, the term "R-C" indicates resistance and capacitance. As used herein, the term "Rx" indicates receiver (or receive). As used herein, the term "Tx" indicates transmitter (or transmit). As used herein, the term "TRX" indicates transceiver. As used herein, the term "UCIe" indicates Universal Chiplet Interconnect Express. As used herein, the term "Vref" indicates reference voltage. As used herein, the term "Vin" indicates input voltage. As used herein, the terms "serially coupled," "serially connected," and "connected in series" are synonymous to each other and indicate a serial connection between two or more components/circuits where the serial connection can be based on a direct or indirect electrical connection between the two or more components/circuits. As used herein, the terms "parallel coupled," "parallel connected," and "connected in parallel" are synonymous to each other and indicate a parallel connection between two or more components/circuits where the parallel connection can be based on a direct or indirect electrical connection between the two or more components/circuits.

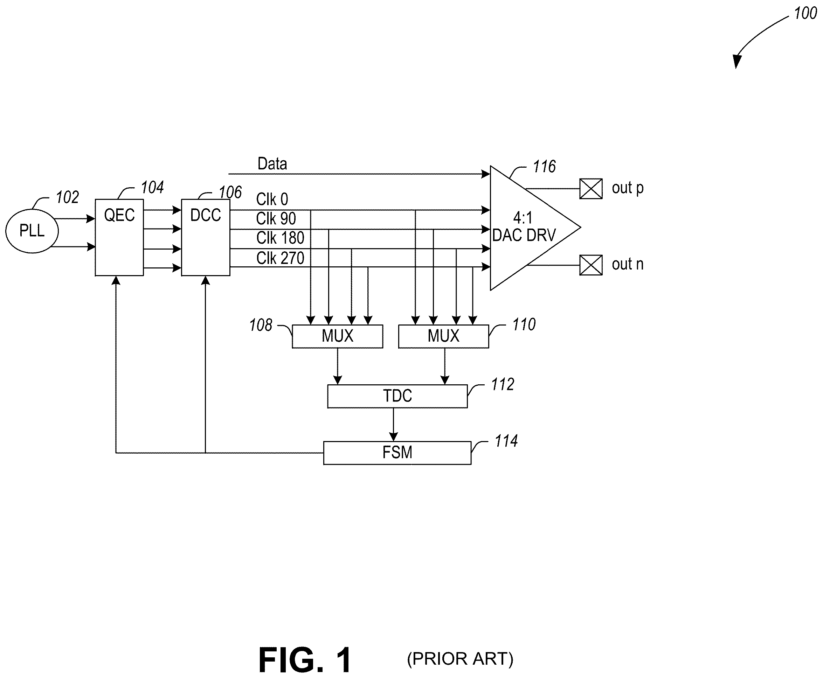

The disclosed techniques (e.g., as discussed in connection with FIGs. 1-22) include minimizing the EOJ value by sensing the clocks' phase spacing error from the Tx driver's output. In this regard, the sensed phase spacing error is accurate as it is based on sensing the output signal (i.e., senses the points where the EOJ specification can be checked in post-silicon). In this regard, the disclosed techniques are used to achieve compliance with the EOJ specification to enable high-speed SerDes transmitters with high data rates (e.g., 224 Gbp/s and beyond). In some aspects, a phase error monitor can be configured to sense phase spacing errors according to the disclosed techniques.

One way to address the EOJ is to incorporate clock phase spacing sensors in the transmitter's clock path. Another solution involves utilizing a slice replica of the transmitter to detect the phase spacing error.

The clock phase spacing sensor in the clock path is described in connection with FIG. 1.

FIG. 1 is a block diagram of a transmitter architecture 100 using clock phase sensing by multiplexers. Referring to FIG. 1, the transmitter architecture 100 includes a phase-locked loop (PLL) circuit 102, a quadrature error corrector (QEC) circuit 104, a duty cycle corrector (DCC) circuit 106, multiplexers (MUXs) 108 and 110, a time-to-digital converter (TDC) circuit 112, a finite state machine (FSM) circuit 114, and a driver (DRV) circuit 116. The driver circuit is configured to output a transmit signal at pads "out p" and "out n."

As illustrated in FIG. 1, the transmitter architecture 100 is based on connecting four clocks that trigger the DRV circuit 116 to two 4:1 multiplexers (MUXs 108 and 110). Each MUX selects which clock phase is sent to the TDC circuit 112. The TDC circuit 112 calculates the phase spacing between the clocks and the duty cycle. The output from the TDC circuit 112 is sent to the FSM circuit 114, which calculates any phase alignment error and duty cycle error. A correction code is then generated and sent to the QEC circuit 104 and the DCC circuit 106 to correct the quadrature and duty cycle of the clocks.

The challenging aspect of this approach is ensuring that the random mismatch between the two MUXs 108 and 110 and the accuracy of the TDC circuit 112 is significantly smaller than approximately EOJ/4. Specifically, at a data rate of 116 Gbps, the EOJ is less than 400 fs, according to the CEI OIF specification. Consequently, EOJ/4 amounts to 100 fs. Additionally, there is a systematic error in the phase spacing between the input of the digital-to-analog converter (DAC) driver (e.g., DRV circuit 116) and the output signals (at pads out p and out n) that add up to the sensing part.

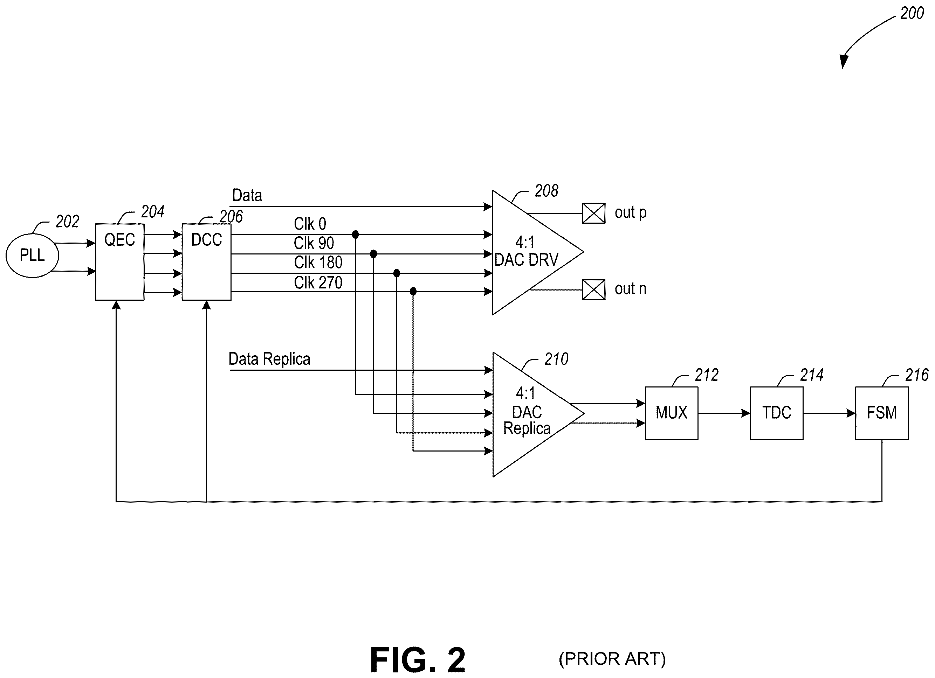

An approach based on using a slice replica to sense the Tx phase spacing error is illustrated in FIG. 2.

FIG. 2 is a block diagram of a transmitter architecture 200 using a slice replica for clock phase sensing. Referring to FIG. 2, the transmitter architecture 200 includes a PLL circuit 202, a QEC circuit 204, a DCC circuit 206, a DRV circuit 208, a replica DRV circuit 210, a MUX 212, a TDC circuit 214, and a FSM circuit 216. The DRV circuit 208 is configured to output a transmit signal at pads "out p" and "out n."

In the approach illustrated in FIG. 2, the replica DRV circuit 210 is used to detect the phase alignment error of the clocks. The replica DRV circuit can be a copy of one of the DAC DRV segments. A separate data path is employed to transmit clock patterns for sensing the phase alignment and duty cycle errors of the clocks. One of the outputs of the replica is selected, and the TDC circuit 214 converts the sensed signal to a digital code that is sent to the FSM circuit 216.

Similar to the transmitter architecture 100 of FIG. 1, the transmitter architecture 200 is configured based on the FSM circuit 216 calculating the phase spacing and duty cycle error of the clocks and then sending correction codes to the QEC and DCC circuits. Theoretically, in this technique, the systematic error is zero. However, there is a random mismatch between the replica DRV and the DAC DRV circuits. To minimize this error, it is possible to find the offset between the DAC DRV and the replica DRV circuits by sending the same clock pattern in both the DAC and the replica DRV circuits. However, this approach is not allowed in every transmitter protocol, such as PCIe.

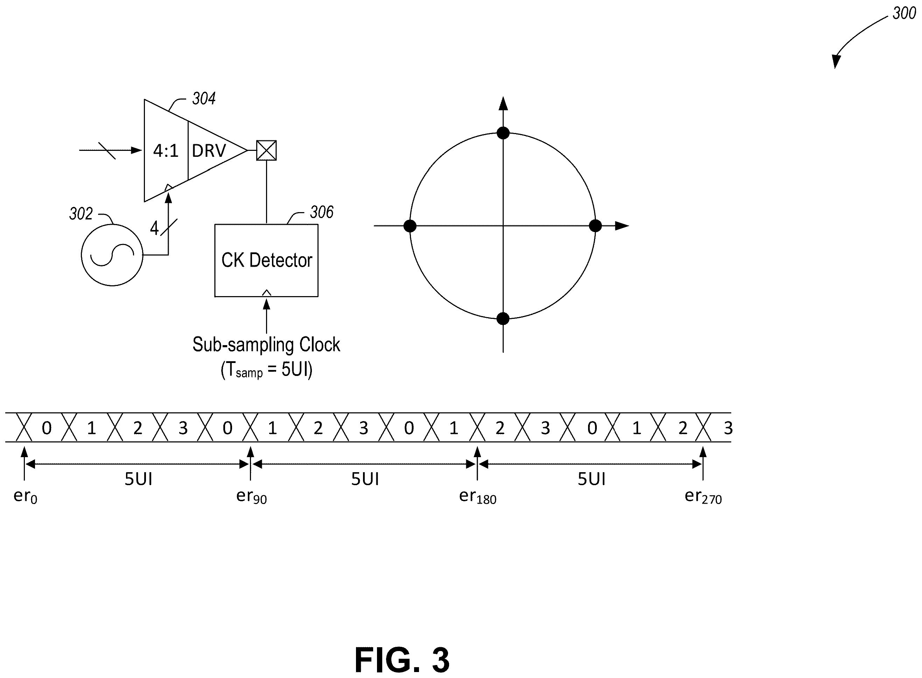

The disclosed techniques (e.g., as described in connection with FIG. 3 - FIG. 5) can be used to minimize the EOJ value by sensing the clocks' phase spacing error from the Tx driver's output.

The circuits of FIG. 3 - FIG. 5 can be used in SerDes PHYs with a competitive advantage for scaling data rates to 224Gb/s and beyond. In some aspects, aggressive even-odd jitter (EOJ) specifications can be set into standards like Ethernet and OIF due to the availability of the techniques disclosed by FIG. 3 - FIG. 5 for meeting tighter specifications. The tighter EOJ specification also improves signal-to-noise ratio, providing a better bit error rate and/or longer channel reach. The following are additional advantages of the disclosed techniques:
(a) The disclosed detector is more accurate in comparison to prior art detectors because it identifies the points where the specification is checked in post-silicon testing in the lab (namely, at the output of the TX driver). The disclosed techniques can be used for achieving optimal EOJ result by minimizing the EOJ and maximizing the Signal-to-Noise and Distortion Ratio (SNDR).
(b) In some aspects, the PHY with higher data rates, such as 224 Gbps PAM4 and 448 Gbps PAM4/6, can be configured with a minimal EOJ value on the order of 200 and 100 fs, respectively, and the disclosed techniques can be used for handling such challenging requirements.
(c) Existing phase detectors do not use direct Tx phase error detection based on the disclosed techniques.

EOJ is a challenging parameter for high-speed Tx SerDes operating above 100 Gbps PAM4 (50 Gbaud). This parameter measures the difference in symbol duration width between the even and odd transmitted positions. When the final stage of the Tx is an ideal N-to-1 MUX, this difference arises from the phase alignment errors between the N phases of the strobing clocks.

In the specifications for 100 Gbps PAM4 protocols as per ETH/OIF standards, the EOJ has to be less than 400 fs. Therefore, a 4:1 MUX driver demands a maximum phase error spacing of about 400 fs/3, approximately 133 fs. At 224 Gbps PAM4, this requirement reduces to about 60 fs, and for 448G PAM6 with a 4:1 MUX driver, the requirement reduces to about 30 fs. Consequently, accurately detecting the phase spacing error becomes highly challenging, but can be achieved using the disclosed techniques.

Most clock sensors are typically placed at the end of the clock path. However, a problem arises because the driver is not ideal, and there may be differences between the muxes. A DAC-based driver consists of tens of parallel 4:1 MUXes. At very high baud rates, there will be noticeable systematic and non-systematic mismatches between the sensing point and the output of the Tx driver.

One possible technique to address this issue is introducing a replica slice, which can help cancel the systematic error. However, the non-systematic error may persist. If the replica is not large enough, the error could be significant.Alternatively, we can calibrate the replica against the Tx driver output. While this solution may be suitable for ETH and Optical Internetworking Forum(OIF) protocols, it may not be applicable for PCIe protocols.

To minimize errors, a sensor can be positioned at the output of the driver to calibrate to the actual timing metric that will be checked during compliance testing. Theoretically, if the sensor is ideal, the phase spacing error is only limited by the maximum step size of the phase error correction block in the clock distribution. A sensor can detect each transition of the Tx, but this would require a sensor with very high bandwidth, which is impractical to implement. Instead, the disclosed techniques use a sensor placed on the Tx output pads that operates at a much lower clock frequency to subsample the Tx output.

FIG. 3 is a simplified block diagram of a phase error monitor 300, in accordance with some embodiments. Referring to FIG. 3, the phase error monitor 300 includes a DRV circuit 304, a clock generator circuit 302, and a clock detector circuit 306.

FIG. 3 illustrates a block diagram of a 4:1 MUX Tx driver (e.g., DRV circuit 304). The driver transmits a different symbol during each unit interval (UI). Instead of sampling each symbol transition, the clock detector circuit 306 performs subsampling with a sampling period Tsamp=4*N+1 UI, so T mod 4=1 UI and N is a positive integer number. This allows a detector to track each zero-crossing derived from a different clock phase at the subsampling clock frequency. For large N values, Tsamp becomes large enough such that it is practical to design a clock detector.

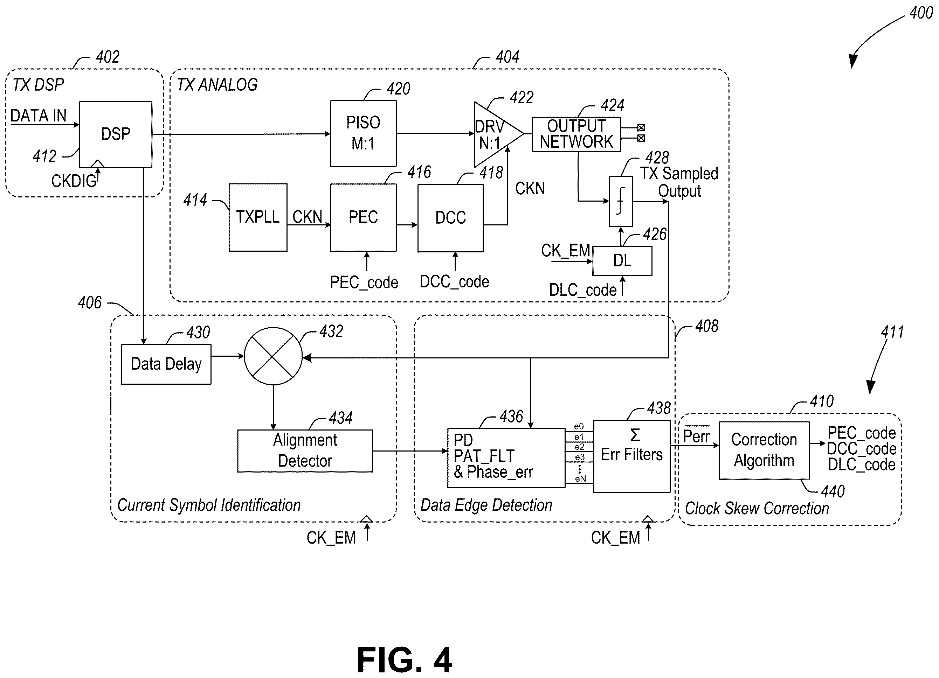

FIG. 4 is a block diagram of a transmitter architecture with a phase error monitor and an N:1 multiplexed driver, in accordance with some embodiments. Referring to FIG. 4, the Tx architecture 400 includes a Tx digital signal processing (DSP) circuit 402, a Tx circuit 404, a current symbol identification circuit 406, a data edge detection circuit 408, and a clock skew correction circuit 410.

The DSP circuit 402 includes a DSP 412 configured to generate Tx data communicated to the Tx circuit 404 and the current symbol identification circuit 406.

The Tx circuit 404 includes a parallel-in-serial-out (PISO) circuit 420, a Tx DRV circuit 422, an output network circuit 424, a PLL circuit 414, a phase error correction (PEC) circuit 416, a DCC circuit 418, a slicer circuit 428, and a delay line circuit 426.

The current symbol identification circuit 406 includes a data delay circuit 430, a multiplier circuit 432, and an alignment detector circuit 434.

The data edge detection circuit 408 includes a pattern filter circuit 436 and an error filter accumulator (EFA) circuit 438.

The clock skew correction circuit 410 includes a signal correction circuit 440 generating correction codes 411.

In some aspects, the Tx DRV circuit 422 serializes data with a width of W = M x N bits (DATA IN) using an input clock CKDIG with a period of M x N x UI. This process can be accomplished through the PISO circuit 420, which converts the DATA IN from M x N bits to N bits of data, followed by a driver stage that serializes the N bits into a differential output. The output from the driver feeds into the output network stage, which enhances the Tx bandwidth by mitigating the effects of parasitic capacitance from the output driver, ESD diodes, and package.

A clock signal, denoted in FIG. 4 as CKN, with a period of N x UI, is utilized to transmit the data in the N:1 driver. For this setup, N equally spaced phases, each with a period of N x UI, can be used. Any deviations in the phase spacing between the CKN phases can lead to a time jitter or EOJ at the Tx DRV circuit output pads.

The N phases of CKN are generated by the PLL circuit 414, which produces differential CK_N clocks. The PEC circuit 416 then generates the N phases and maintains the correct phase spacing. The DCC circuit 418 adjusts the duty cycle of each clock, ultimately transmitting the N phases of CKN to the N:1 driver.

The current symbol identification circuit 406, the data edge detection circuit 408, and the clock skew correction circuit 410 can be configured as eye monitor (EM) circuitry. To effectively count only the data transitions in the error filters, it is essential to identify or correlate the sampled data to the input digital data that is being transmitted. Additionally, the disclosed techniques can include determining whether the sampling of the CK_EM clock is occurring late or early relative to the Tx output data transitions.

In some aspects, the correlation between the DSP data being transmitted to the Tx DRV output is established by positioning the CK_EM clock far from the output data transition (ideally close to the center of the "data eye"). The DSP then delays the data until high alignment is detected in the alignment detector block. Once a correlation is identified in the current symbol identification block, the data edges are detected.

In some aspects, the CK_EM edge can be positioned closer to the data edge transition. A pattern filter circuit 436 (PAT_FLT) processes the sampled signal, allowing the phase error to be assessed only for the specific data transitions that are configured, such as the rising edge, falling edge, or both edges.

The phase error will produce an output signal of +1 or -1, depending on whether the sampled data arrived earlier or later relative to CK_EM. The phase error is then sequentially sent to each of the outputs e0 through eN. Starting with e0, the output affects e1 and continues up to eN before repeating the cycle, eventually outputting to e0 again. If the data arrives on time, the output will be 0. The error filter counts the up or down transitions or remains idle based on the values of the e0 to eN results. The outcomes are averaged over P cycles of CK_EM, producing a vector of errors named Perr at the output of the error filters.

Subsequently, a correction algorithm used by the signal correction circuit 440, which can be LMS-based, generates correction codes of PEC_code, DCC_code, and DLC_code to adjust the phase error spacing, duty cycle error, and CK_EM delay skew. This correction operates continuously during the data mode of the Tx, enabling adjustment of clock edges in response to temperature drifts.

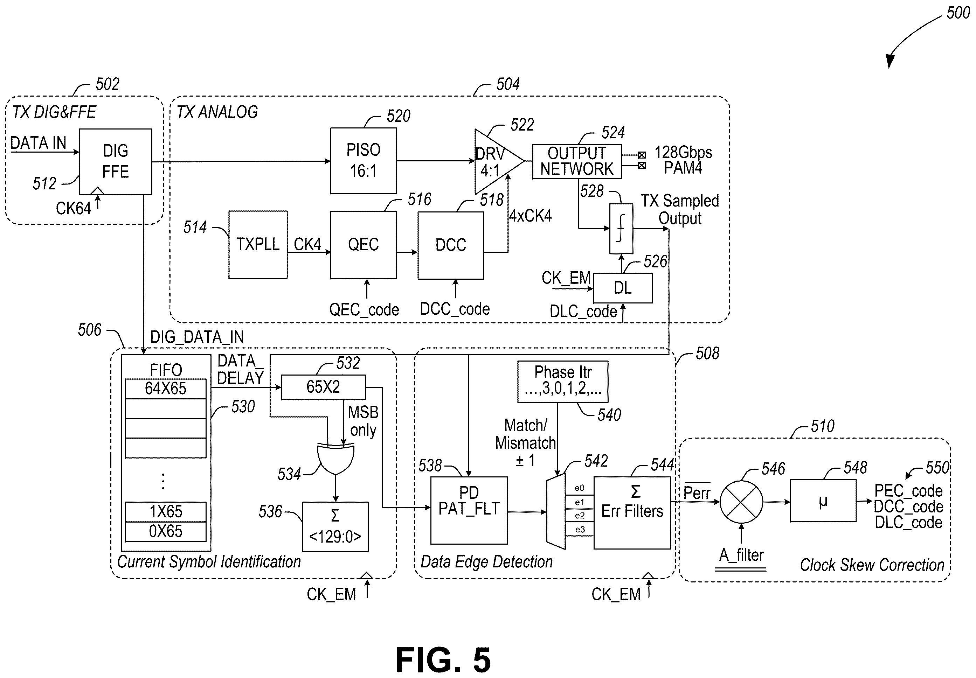

A block diagram of a Tx architecture transmitting at a maximum rate of 128 Gbps PAM4 is shown in FIG. 5.

FIG. 5 is a detailed block diagram of a transmitter with a phase error monitor and a 4:1 multiplexed driver. Referring to FIG. 5, the Tx architecture 500 includes a Tx DSP circuit 502, a Tx circuit 504, a current symbol identification circuit 506, a data edge detection circuit 508, and a clock skew correction circuit 510.

The DSP circuit 502 includes a DSP 512 (e.g., a digital feed-forward equalizer) configured to generate Tx data communicated to the Tx circuit 504 and the current symbol identification circuit 506.

The Tx circuit 504 includes a PISO circuit 520, a Tx DRV circuit 522, an output network circuit 524, a PLL circuit 514, a QEC circuit 516, a DCC circuit 518, a slicer circuit 528, and a delay line circuit 526.

The current symbol identification circuit 506 includes a buffer 530, a reference memory 532, an XOR gate 534, and a counter circuit 536.

The data edge detection circuit 508 includes a pattern filter circuit 538, a phase iterator circuit 540, a multiplexer 542, and an EFA circuit 544.

The clock skew correction circuit 510 includes a multiplier circuit 546 and a prioritization coefficient circuit 548 that generates correction codes 550.

The Tx DSP circuit 502 operates with a 64 UI clock, where 1 UI equals 1/64G or approximately 15.5 ps. It generates 64 UI of data each clock cycle to transmit, and each UI of data is 2 bits because it uses PAM4 encoding.

Within the Tx DSP circuit 502, the 64 2-bit data is sent to the FFE which then outputs 64 7-bit data (for the 7-bit DAC). The PISO circuit 520 serializes it from 7x64 to (4+7)x4=1 lx4, where 4 represents the binary part of the DAC and 7 bits are thermometric.

The 4:1 MUX driver (e.g., the Tx DRV circuit 522) serializes its input data using the 4 phases of CK4, a 4UI clock. Assuming the clocks are differential, each rising edge of the clock phase is responsible for the beginning of transmission of one symbol at the driver output.

In some aspects, the Tx clock path starts from the PLL circuit 514, which generates a 4UI differential clock labeled CK4. The reference clock, CK_EM, has a clock period of 65 UI and can be used as the subsampling clock for the eye monitor. The clock path generates 4 phases of the 4UI clock using delay lines. The QEC and DCC circuits correct the phase spacing error and their duty cycles, respectively.

To meet the EOJ jitter spec, the phase spacing error between the clocks and duty cycle error can be less than about ~100 fs. To achieve this configuration as a high-accuracy adaptive calibration, the EM can operate during the data mode.

An example calibration sequence is discussed below.

In some aspects, the EM retrieves data from the Tx output network taps. The data goes through a slicer (e.g., slicer circuit 528) that operates at clock signal CK_EM and provides a 1-bit value (labeled as Tx sampled output) that helps determines the early-late timing error signal and enters the subsequent circuits for further processing. It sets values to the QEC_code, DCC_code, and Delay Line Corrector code (DLC_code) according to the calculated phase spacing error. Here, the delay line (DL) circuit 526 controls the slicer's sampling time point through the DLC control lines.

In some aspects, the operation of the disclosed phase error monitor (PEM) can be summarized in the following four stages:
(a) Symbol identification stage- calibrates the alignment detector to match the Tx sampled output (transmitted symbol from the Tx DRV circuit) to the output of the alignment detector.
(b) Data edge sampling stage - moves the EM clock (CK_EM) to the edge of the "data eye" where data transitions occur.
(c) Data filtering and accumulation - collects N error filter values where N equals the number of clock phases.
(d) Knob mapping stage - maps the error filter values to the correct clock phase by using QEC_code or DCC_code knobs.
(e) Clock skews correction stage - fixes the CKN and CK_EM skews using the measured error filter values and varying QEC_code, DCC_code, and DLC_code.

In some aspects, the following configurations can be used during the symbol identification stage.

In this stage, the goal is to match the data transmitted at the DSP output with the data transmitted at the output pads (Tx sampled output). The Tx sampled output is achieved by sampling the output Tx data at the EM clock edge approximately 0.5 UI after the Tx data transition, which is the middle of the eye diagram. The alignment detector will delay the DSP output to account for the analog data delay between the output of the DSP and the Tx output pads.

In some aspects, the calibration process includes identifying a strong correlation between the data read from the FIFO and the actual data obtained from the output pad.

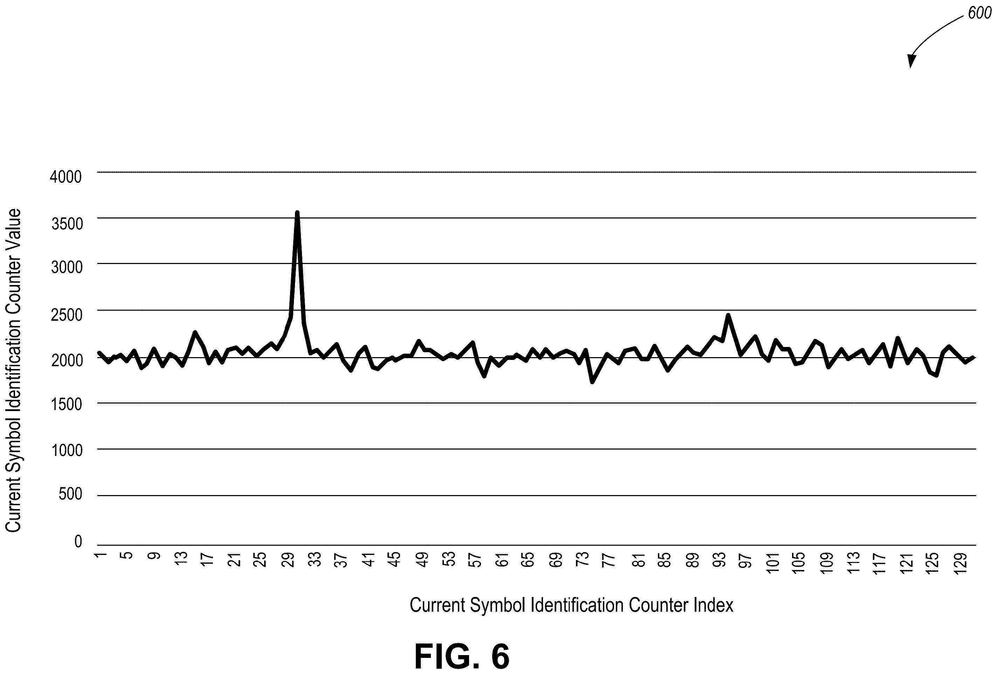

FIG. 6 is a measurement results graph 600 of silicon results for the symbol identification stage, in accordance with some embodiments. In FIG. 6, one possible implementation of the current symbol identification circuit counter values is shown. The DSP output is delayed using a FIFO, and the separation between the read and write pointer of the FIFO (e.g., buffer 530) represents the analog data delay. The FIFO, with a length of 4160, is filled by the WR pointer with the currently transmitted data from the DIG at a clock frequency of 64 UI. This data is then read by the RD pointer operating at the CK_EM clock frequency, which can be 65 UI. Each read from the FIFO outputs two rows of 65 symbols (65x2x2 bits). If each PAM4 symbol has a uniform probability, then it is sufficient to compare only the most significant bit (MSB) of each symbol.

In some aspects, the disclosed techniques are used to find a high correlation value stored in the accumulators (more than 85 or 90% success rate) in each reading sequence. If the read and write pointer separation is varied for different possible values and fails, then processing is likely not in the eye-opening and the DLC_code can be changed until a match that results in an accumulator with a high stored value is found. At this point, the symbol identification stage is finished, and the data read from the FIFO is synchronized with the data being transmitted at the TX output pads.

FIG. 6 presents example results for symbol identification. In some aspects, 130 counters can be used, which simultaneously attempt to match the Tx sampled output against 130 consecutive FIFO outputs. If the correct FIFO readpointer is selected, one index is expected to match well, while all the other indexes can match approximately 50% of the time (which is due to random chance). FIG. 6 indicates that index 29 matches 3559 out of 4096 times (86.9%), while the other indexes match around 50% of the time. Based on this data, it can be concluded that index 29 accurately matches the sampled TX output data.

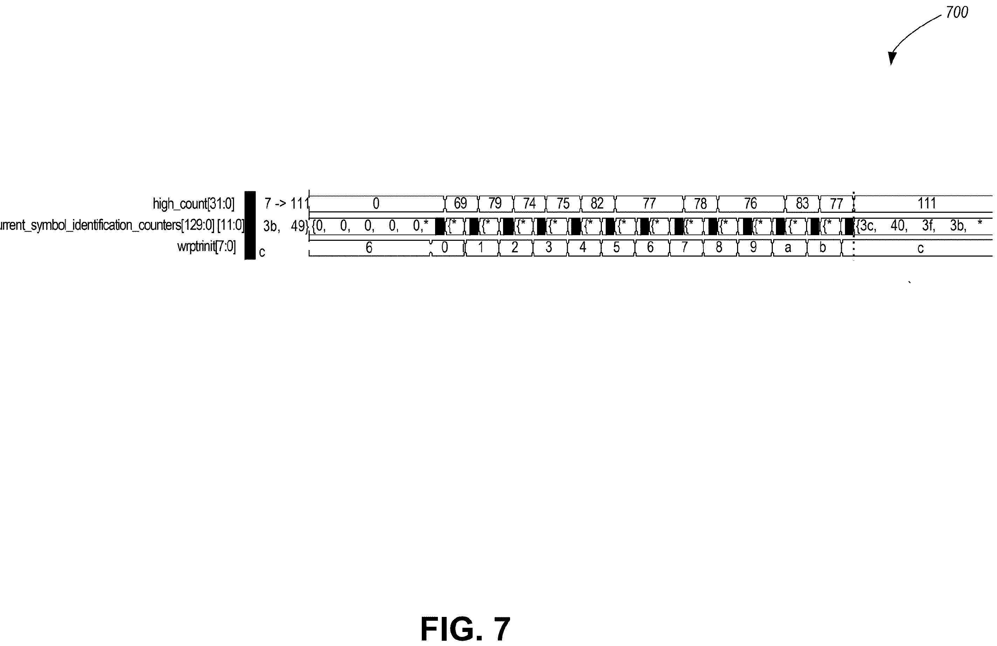

FIG. 7 is a simulation results graph 700 of behavioral model (BMOD) simulation results for the symbol identification stage, in accordance with some embodiments. FIG. 7 shows the BMOD simulation result where the data rate of the Tx is 128 Gbps PAM4, which translates to 1 UI of 15.625 ps.

During simulation, 130 counters can be used, which simultaneously attempt to match the transmitted data against 130 consecutive FIFO outputs. The wrptrinit represents the delay from the Tx FFE to the TX pad. The value of it is increased until a current symbol identification counter matches more than 80% of the time. The maximum value among the current symbol identification counters is shown in the high_count signal. For each wrptinit value, 127 samples are taken. When there is no match, then one expects all the counters to be roughly 50% of the count. When the wrptrinit is set to 7'hc (decimal 12) there is a location that matches 87.4% of the time (high_count equals 111).

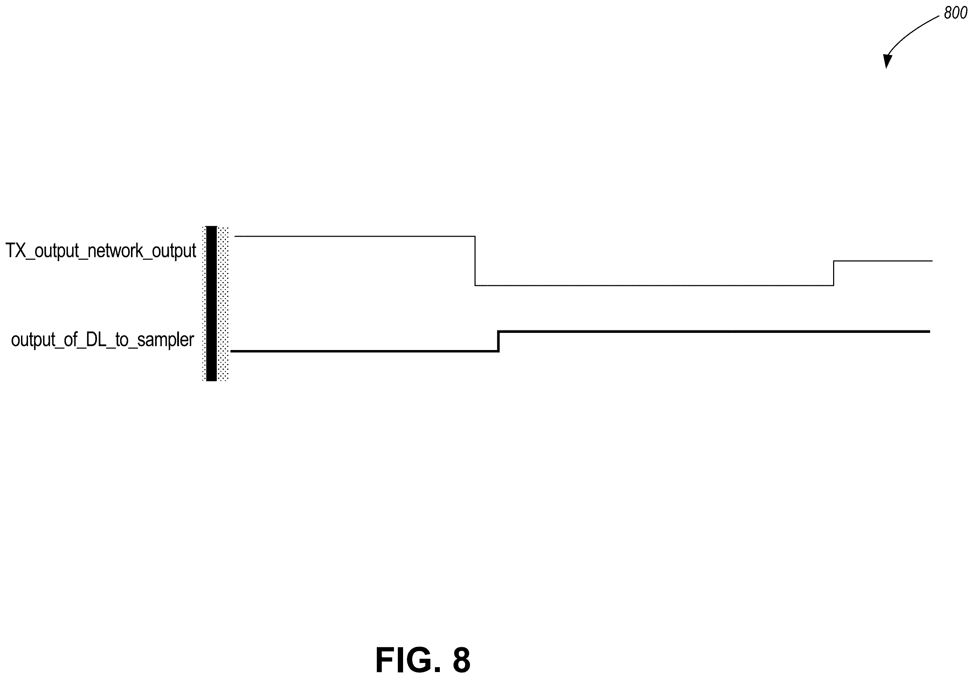

FIG. 8 is a simulation results graph 800 of a sampling clock position at the current symbol identification stage, in accordance with some embodiments. FIG. 8 shows that the EM's sampling clock (output of the delay line, which is a delayed version of ck_em) is reading the Tx pad data (Tx output network output) 1 ps after its transition, indicating that the data is being sampled far enough from the edge.

The following configurations can be used for the data edge sampling stage.

In this stage, the EM DL can be adjusted to the data transition (the edge of the eye diagram) using the DLC_code values, which have a coarse and fine component. This adjustment can be identified when the index of the matching counter is shifted by one index. Positioning the EM sampler at the zero crossing of the transmitted data can be used for measuring phase spacing error.

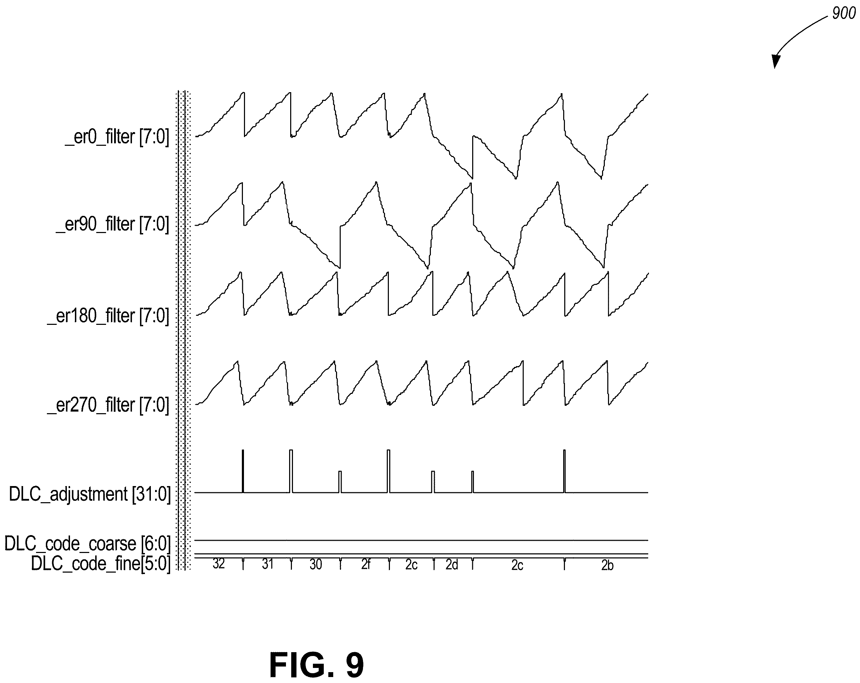

FIG. 9 is a simulation results graph 900 of error monitor (EM) clock delay movement toward the data edge, in accordance with some embodiments. In FIG. 9, the movement from sampling the data in the middle of the eye toward the data edge transition is depicted. Since processing is not at the eye edge, the eyemon comparator output will match the 1st UI of data. As a result, the error filter values for the 4 phases (Perr is a vector composed of er0_filter, er90_filter, er180_filter, and er270_filter) are all initially 96 (96 samples are taken per adjustment). The DLC_adjustment is the sum of the four error filters. A positive value indicates that the DLC_code fine portion can be decreased to move the eyemon sampler clock closer to the data edge.

At DLC code fine position equal to 30, the eyemon clock is close enough to the data transition that er90_filter becomes negative because it matches the 2nd UI. The sum of the DLC_adjustment is smaller but still positive, so the DLC_code_fine continues to decrease.

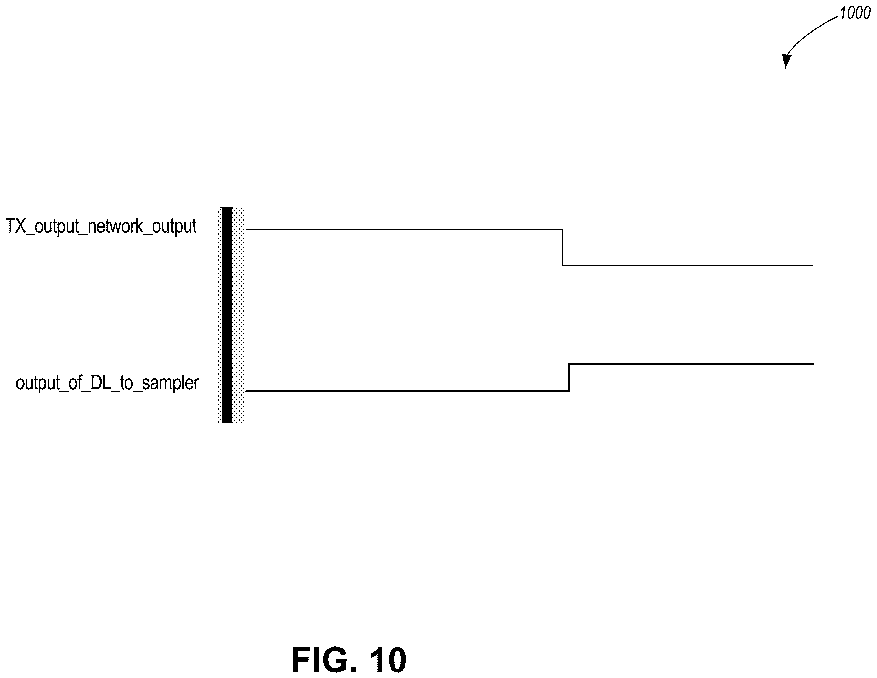

FIG. 10 is a simulation results graph 1000 of the EM sampling clock at the data edge, in accordance with some embodiments.

Eventually, the DL delay is adjusted such that the eyemon sampler clock (output of DL to the sampler) leads the TX output network output only by 13 fs (e.g., as illustrated in FIG. 10). The output of DL is now sampling the TX pad output data close enough to its edge for the next steps.

The following configurations can be used for data filtering and accumulation.

At this stage, the TX sampled output has been mapped to the DIG FFE output and moved DL output to the eye edge. Tx output network data transitions (consecutive non-identical symbols) can provide clock duty cycle and phase error information, and hence, the pattern filter circuit can be used to filter out irrelevant data sequences.

In some aspects, the pattern filter circuit can be programmed with patterns of different lengths. Longer patterns will provide greater mitigation against limited bandwidth of the detector circuits. If the data sequence matches the pattern filter circuit programmed pattern for each clock cycle, the Tx sampled output will be compared against the MSB of the two symbols that make the data transition. If the symbol matches the preceding one, the output will be +1. Otherwise, it can match the trailing symbol, and it will output -1. If the data sequence does not match the pattern filter circuit programmed pattern, then 0 will be outputted.

The pattern filter circuit output goes to a set of N accumulators, where N equals the number of clock phases. For each EM clock cycle, a variable called the phase iterator index will increment modulo N, and the accumulator whose number matches the phase iterator index will take the pattern filter circuit output and either increase, decrease, or stay the same.

The following configurations can be used for the knob mapping stage.

In some aspects, the disclosed techniques are used to establish a mapping between the phase iterator index and the CKN clock phases. This means assigning each accumulator i (where i=1,..., N) to a clock phase j (where j=1,.., N). An example approach is to make slight adjustments to one of the DCC_codes or PEC_codes and observe which accumulator's phase iterator index changes more compared to the others on average. Since the clock phases are sampled in a specific order, once one mapping is established, the mappings for all the clock phases are known. For example, for an N=4 system, if adjusting the CK phase 0 DCC_code knob affects the accumulator with a phase iterator index of 1, then adjusting phase 90 affects accumulator 2, phase 180 affects accumulator 3, and phase 270 affects accumulator 0.

The following configurations can be used for the clocks skew correction stage.

In this stage, the CK4 clocks (4 clock phases with 4UI period) edges can be adjusted. This can be achieved by reading the error filter counter values and then multiplying them with an error filter matrix to determine how much to adjust each of the knobs that control the CK4 and CK_EM clocks.

In some aspects, the relationship between the error filter counter and the clock knob values is given by the following Equation 1: *A* × *Perr = Kctl,* or the following Equation 2: $\left(\begin{matrix}- 1 & 0 & 1 & 0 \\ 0 & - 1 & 0 & 1 \\ - 1 & 1 & - 1 & 1 \\ 1 & 1 & 1 & 1\end{matrix}\right) \times \left(\begin{matrix}er 0 _ filter \\ er 90 _ filter \\ er 180 _ filter \\ er 270 _ filter\end{matrix}\right) = \left(\begin{matrix}{DCC}_{I} _ adjustment \\ {DCC}_{Q} _ adjustment \\ PEC _ adjustment \\ DLC _ adjustment\end{matrix}\right) .$

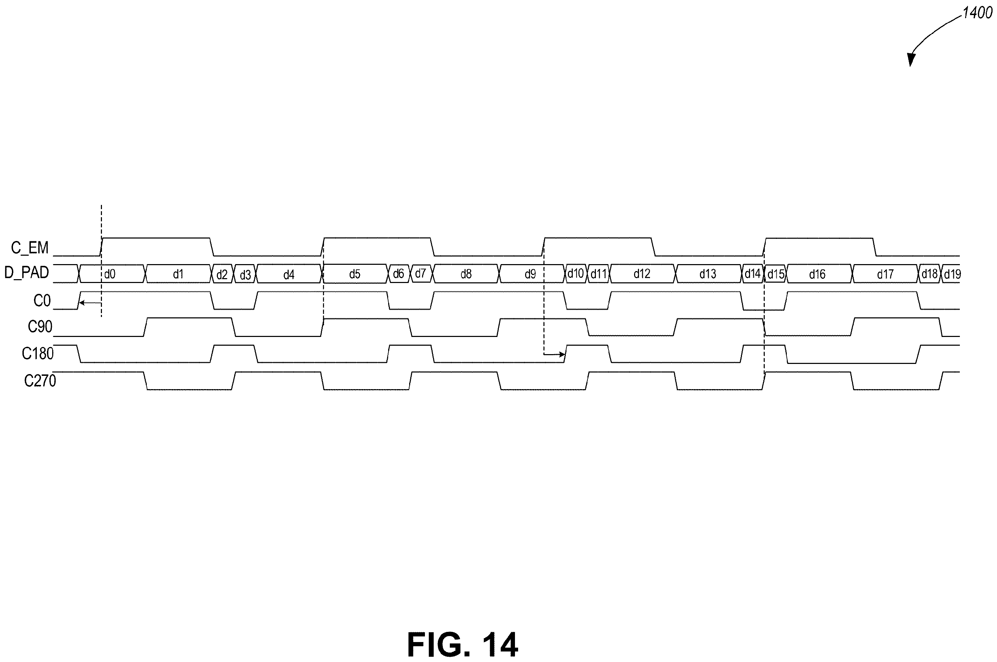

In some aspects, the phase error filter matrix (A) and averaged error filter vector (Perr) are used alongside the knob control vector (Kctl) to correct the clock 4ui and clock EM skews. In some aspects, the entries in the filter matrix A have constant values, determined by the diagrams shown in connection with FIGS. 14-20. These values may change depending on the clock path architecture and the number of phases. The derivation of the 4x4 matrix A is explained herein below.

In some aspects, when the EM is active during data mode, at least coarse calibration can be performed using either a replica slice or a clock detector in the clock path before using the EM block.

Three example scenarios are described below where duty cycle skew is introduced on clock Q, clock I, and I/Q skew, which shows how the EM detects these skews and updates the clock knobs to fix them.

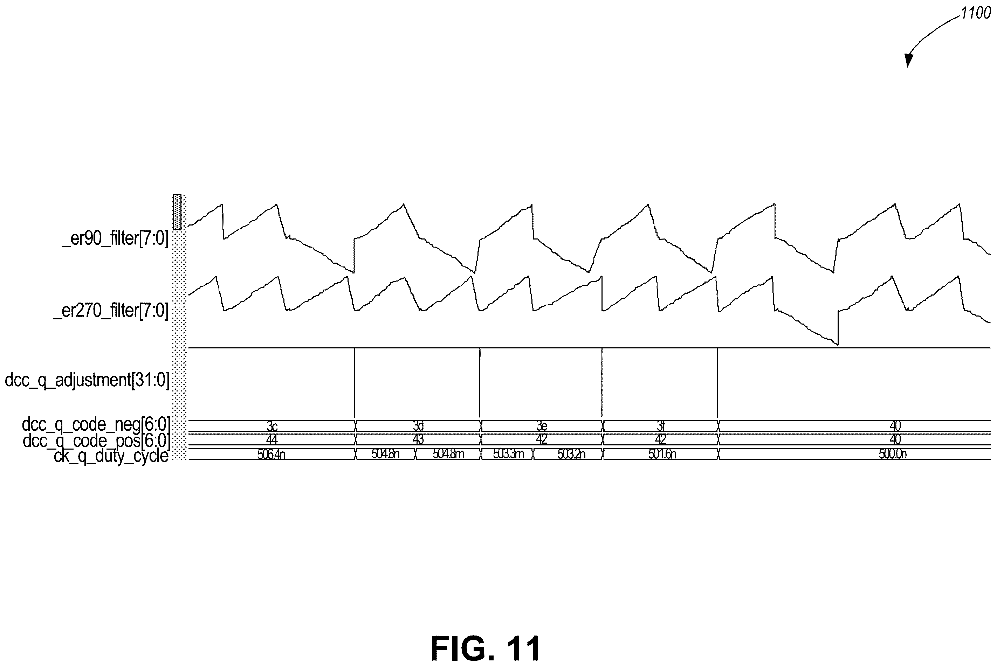

FIG. 11 is a simulation results graph 1100 of fixing duty cycle Q skew, in accordance with some embodiments.

In the given example, the initial duty cycle of clock Q is 0.5064. The value of dcc_q_adjustment is calculated as the difference between er90_filter and er270_filter (see the following Equation 2 for *DCC_{Q}*_adjustment row). When these values are the same, dcc_q_adjustment is 0, and no adjustment is made. However, if they are different, the control signals dcc_q_code_neg and dcc_q_code_pos (the net effect is dec_q_code_pos - dcc_q_code_neg) are adjusted, which changes the ckq_duty_cycle until it adapts to a 50% duty cycle.

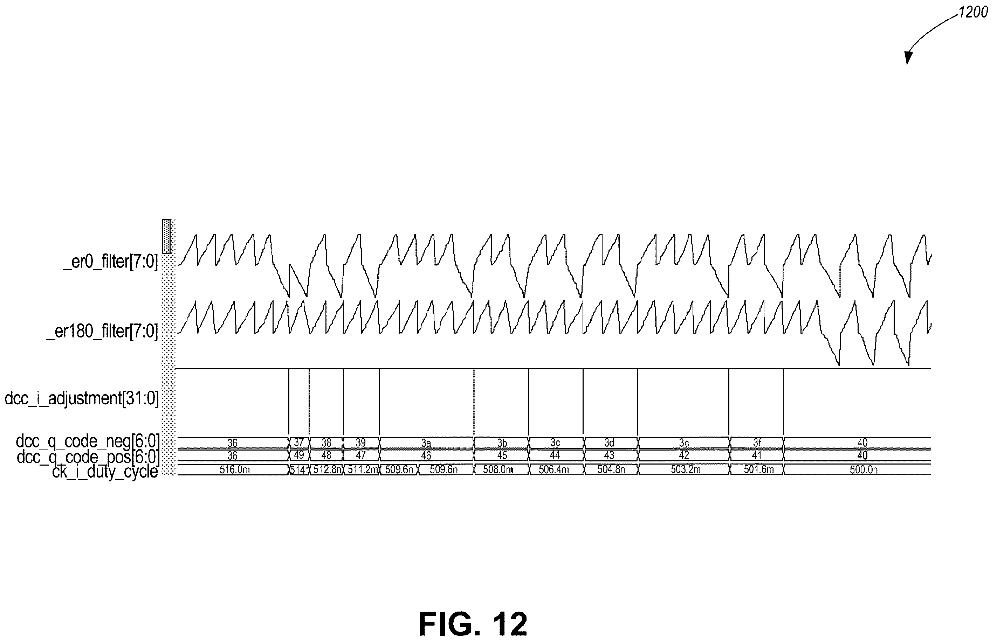

FIG. 12 is a simulation results graph 1200 of fixing duty cycle I skew, in accordance with some embodiments. In the FIG. 12 simulation, the initial duty cycle of clock I is 0.516. Similar to the previous example, the dcc_i_adjustment calculates the difference between er0_filter and er180_filter (see the following Equation 21 for *DCC_{I}_*adjustment row). When these values are the same, dcc_i_adjustment is 0, and no adjustment is made. However, if they are different, the control signals (dcc_i_code_neg and dec_i_code_pos) are adjusted, which changes the ck_i_duty_cycle until it is adapted to a 50% duty cycle.

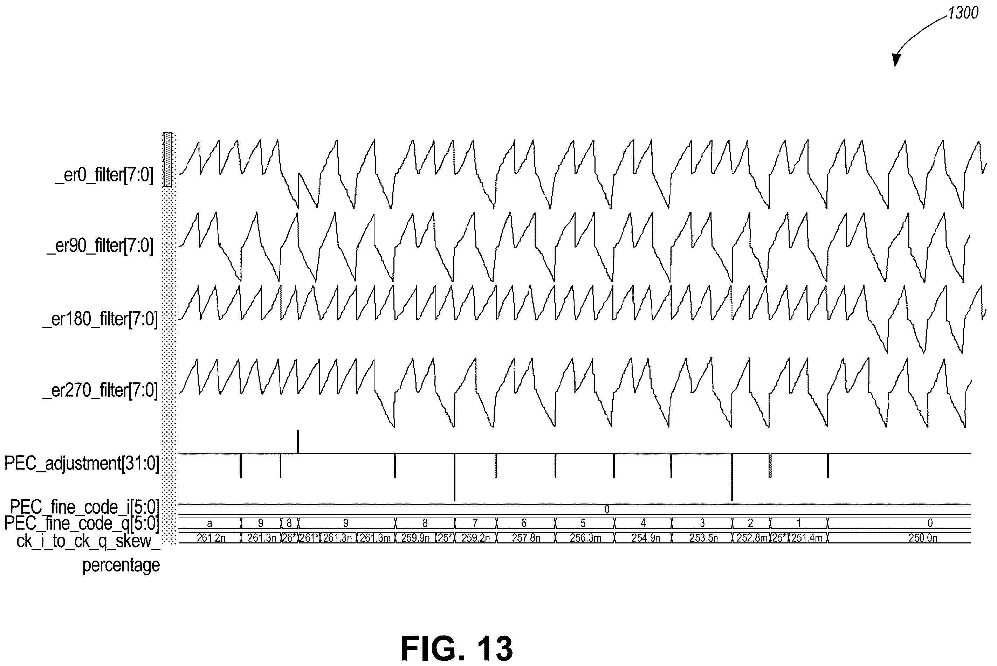

FIG. 13 is a simulation results graph 1300 of fixing skew between clock I and clock Q, in accordance with some embodiments. The simulation associated with FIG. 13 begins with a phase spacing between clock I and clock Q of ck_i_to_ck_q_skew_percentage = 0.2612, where ck_i_to_ck_q_skew_percentage is the time between the rising edge of clock I and the rising edge of clock Q divided by 4 UI period. Hence, the phase spacing between the clocks is 16.34375 ps, which translates to a skew of 718 fs. The goal is to adjust this to 0.25.

The PEC_adjustment calculates the sum difference between er0_filter and er90_filter and the difference between er90_filter and er270_filter (see the following Equation 2 for *PEC_adjustment* row). If there is a difference, the controls PEC_fine_code_i and PEC_code_q are varied until the ck_i_to_ck_q_skew_percentage reaches 0.25.

The description below explains how clock skew, duty cycle error, and quadrature error impact the error filters. The proposed configuration assumes that error filter 0 is responsible for counting the matching or non-matching of C0, error filter 1 counts for C90, error filter 2 counts for C180, and error filter 3 counts for C270. When there is a match between the FIFO symbol and the slicer output, the error filter counter increases, and when there is a mismatch, it decreases. The figures below show the error filter results after N samples.

The following description is associated with the duty cycle error of clock I.

FIG. 14 is a simulation results graph 1400 of the duty cycle error of clock 0 (C0), in accordance with some embodiments. FIG. 14 illustrates an example where the duty cycle of C0 is greater than 50%. Since C180 can be complementary to C0, its duty cycle becomes less than 50%.

Both clocks C90 and C270 remain aligned without any duty cycle skew, maintaining an exact 50% duty cycle. The first edge of D_PAD, where d0 is transmitted, is controlled by the rising edge of C0. As C0 arrives earlier than the C_EM (EM clock), the error slicer will count up. Conversely, because C180 arrives after the rising edge of C_EM, the counter E2 will count down. Since C90 and C270 are free from skew, their rising edges are aligned with the edges of C_EM, which means their counter values will not be affected, as indicated by Table 1 below.

**TABLE 1**

| | E0 | E1 | E2 | E3 |
|---|---|---|---|---|
| DCC_I | +N | 0 | -N | 0 |

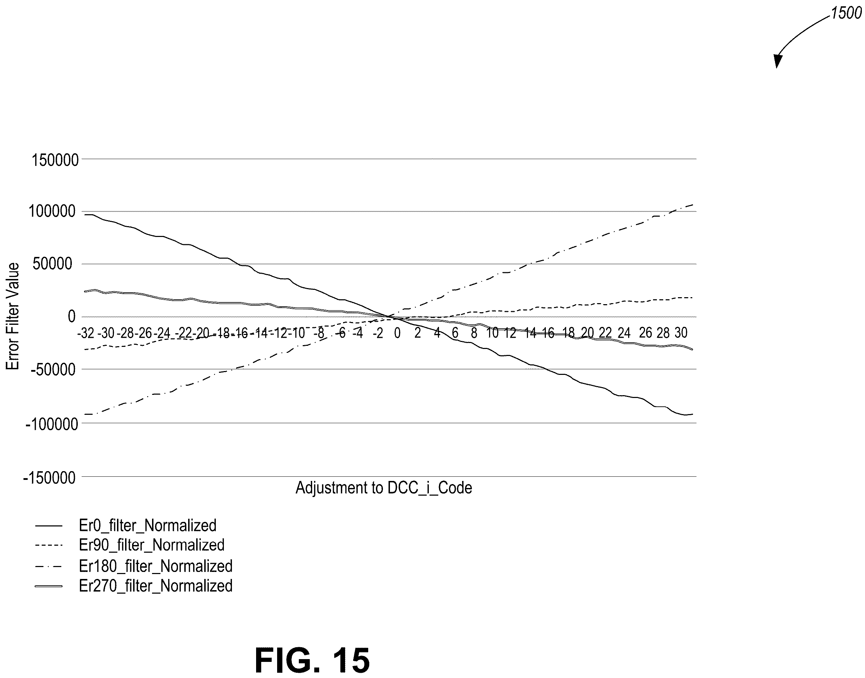

FIG. 15 is a measurement results graph 1500 of the error filter value when there is a clock I duty cycle skew, in accordance with some embodiments. FIG. 15 presents the laboratory measurements of the error filters related to the duty cycle skew of CLK I. As illustrated in FIG. 15, when the duty cycle of clock 0 is too high (indicated by a small index number, which corresponds to the DCC code for clock I), the error filters Er0 and Er180 count high values, as shown in FIG. 14. Conversely, when the duty cycle approaches 50% (index 30), all error filters, on average, count close to zero. However, as the duty cycle decreases (indicated by index values greater than 33), the error counters Er0 and Er180 display values that are opposite to those observed when the DCC code has a small value.

The following description is associated with the duty cycle error of clock Q.

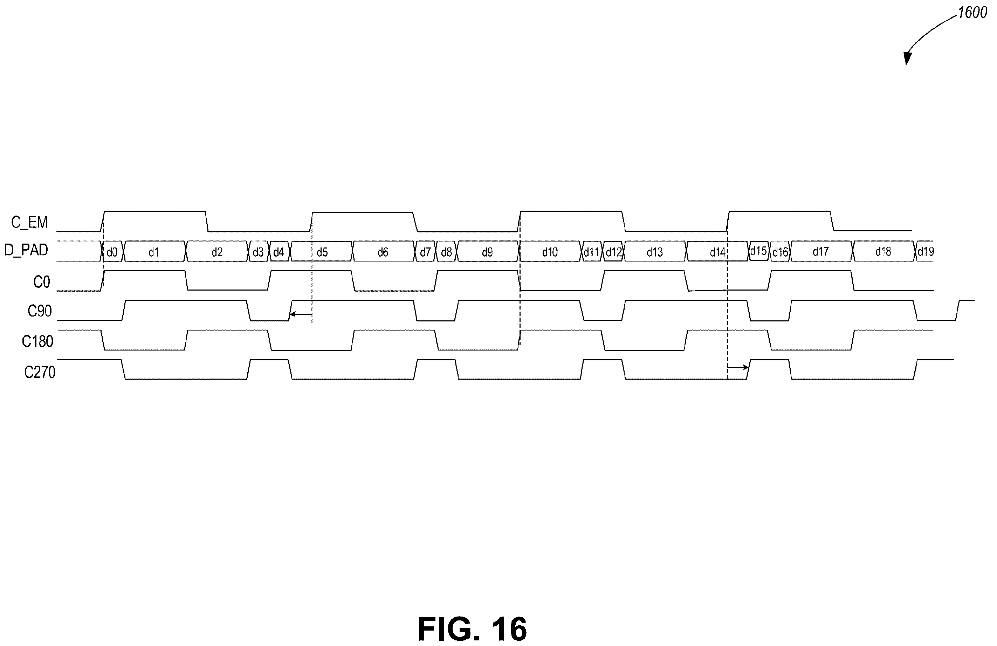

FIG. 16 is a simulation results graph 1600 of the duty cycle error of clock 90 (C90), in accordance with some embodiments.

In this processing scenario, a skew issue can be addressed with clock Q, specifically clocks C90 and C270. Similar to the previous case involving duty cycle skew with clock I, the rising edge of clock C90 arrives earlier than the rising edge of clock C_EM. Consequently, the error counter E1 increments. Since C90 and C270 can be fully differential, the rising edge of C270 arrives later than the rising edge of C_EM, as illustrated in FIG. 16. As a result, the error filter E3 decrements, as illustrated in Table 2.

**TABLE 2**

| | E0 | E1 | E2 | E3 |
|---|---|---|---|---|
| DCC Q | 0 | N | 0 | -N |

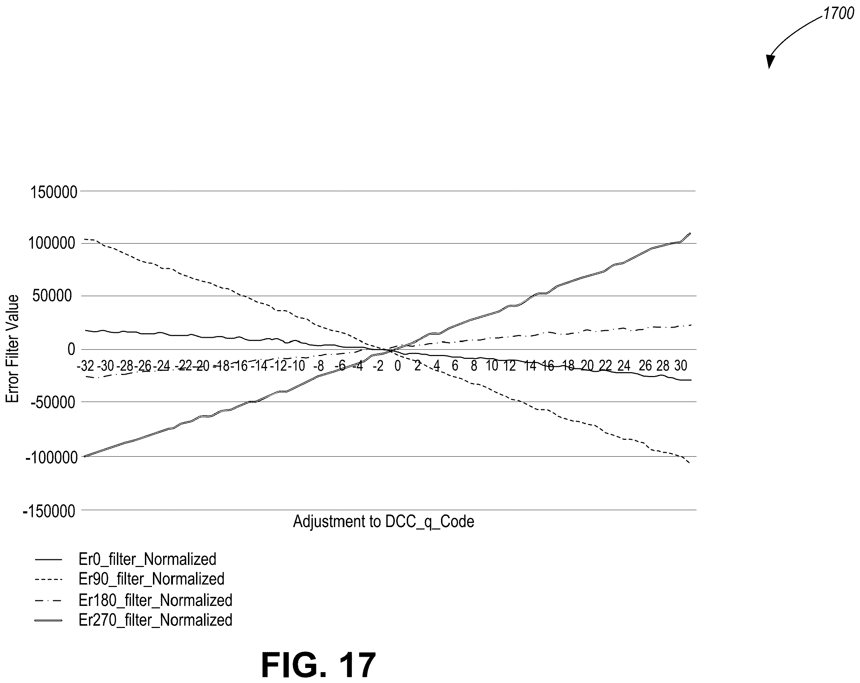

FIG. 17 is a measurement results graph 1700 of the error filter value when there is a clock Q duty cycle skew, in accordance with some embodiments. As shown in FIG. 17, lab measurements of the error filter values for clock Q (c90) duty-cycle skew can be conducted by altering the DCC of the clock Q code. The values of the error filters for small DCC codes of clock Q can be similar to the values shown in FIG. 16.

The following description is associated with the I/Q skew. More specifically, the following description relates to the phase spacing skew between clock I and clock Q.

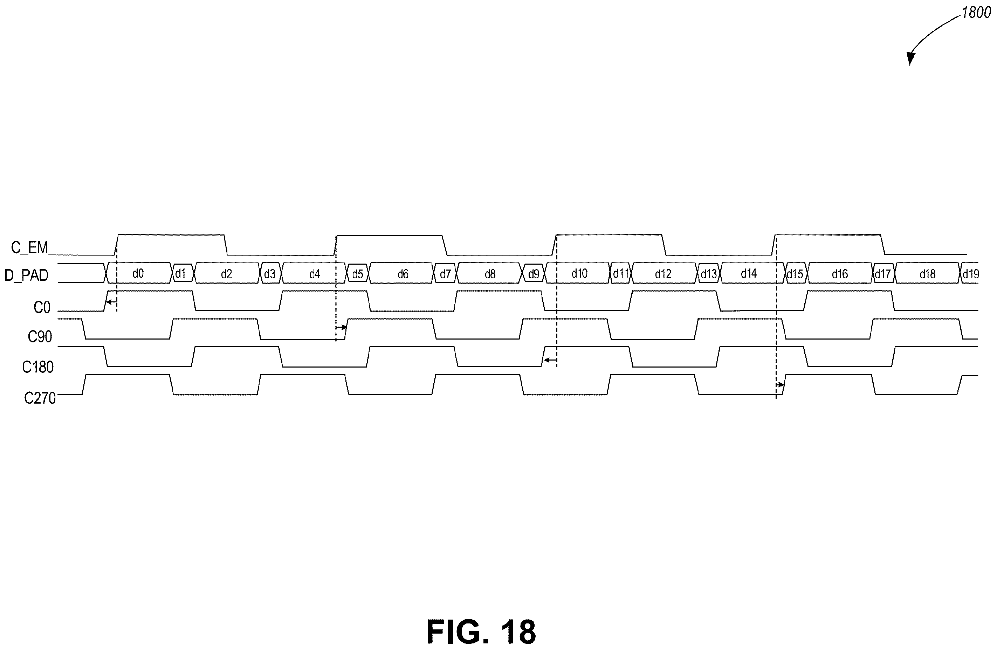

FIG. 18 is a simulation results graph 1800 of quadrature error between clock 0 (C0) and clock 90 (C90), in accordance with some embodiments. FIG. 18 illustrates an example of this skew, where the phase spacing error between C0 and C90 exceeds 1 UI. In this case, the rising edge of C0 arrives before the rising edge of C_EM, while C90's rising edge arrives after that of C_EM. Since C180 and C270 are fully differential with respect to C0 and C90, respectively, opposite edge arrivals of the clocks with respect to C_EM can be observed. This results in the following error counter values listed in Table 3 and also shown in FIG. 18:

**TABLE 3**

| | E0 | E1 | E2 | E3 |
|---|---|---|---|---|
| PEC | +N | -N | +N | -N |

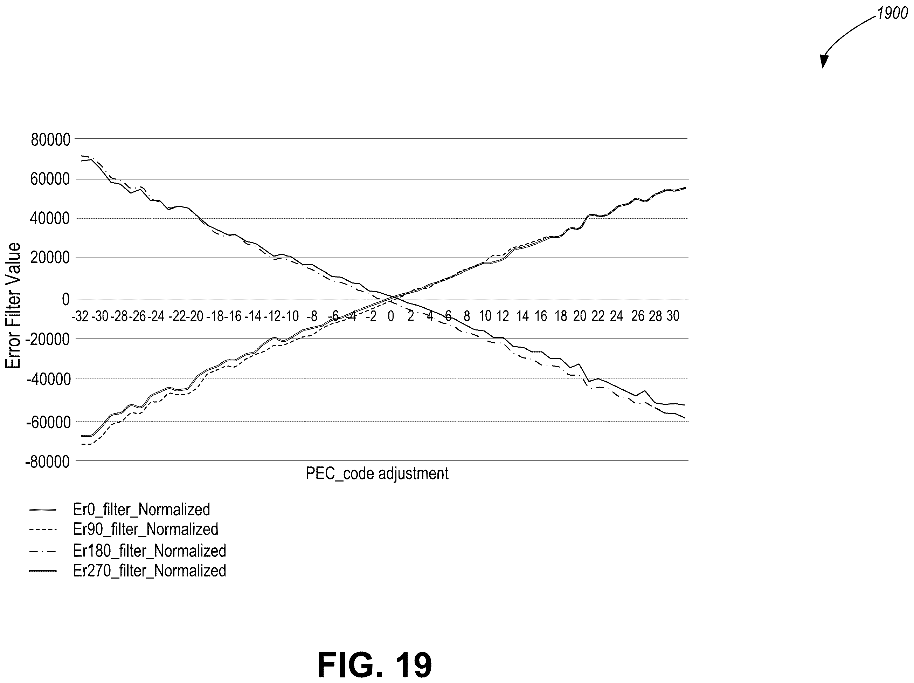

FIG. 19 is a measurement results graph 1900 of the error filter value when there is a clock I/Q skew, in accordance with some embodiments. FIG. 19 illustrates the error filter values when there is a skew between clock I and clock Q. For smaller index values of the QEC code, the phase spacing between C0 and C90 exceeds 1 UI, causing the rising edge of C0 to arrive after the rising edge of the C_EM clock. In this scenario, the error filters for C90 and document number 1 exhibit large negative values, while the error filters for C0 and C90 show large positive values. However, when the phase spacing error between clock I and clock Q is minimized to an index value close to 33, the error filter values approach zero.

The following description is associated with the EM clock skew.

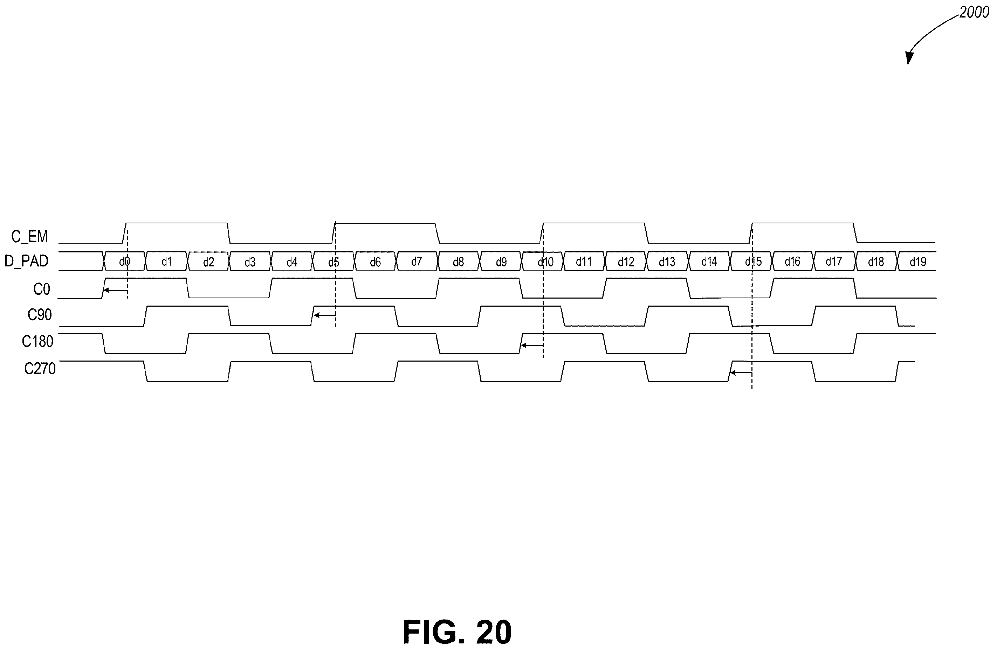

FIG. 20 is a simulation results graph 2000 of the EM clock skew, in accordance with some embodiments.

Another type of clock skew arises from the EM clock, denoted as C_EM. If all high-speed clocks are properly calibrated but C_EM arrives later, as shown in FIG. 20, the error filter counters will increment. Conversely, if the leading rising edges of C_EM occur before the leading edges of C0, C90, C180, and C270, the opposite effect can be observed. The DLC code controls the rising edge of C_EM in relation to the other clock edges: C0, C90, C180, and C270. Example DLC values are illustrated in Table 4:

**TABLE 4**

| | E0 | E1 | E2 | E3 |
|---|---|---|---|---|
| DLC | +N | +N | +N | +N |

In some aspects, the error matrix filter can be derived from the four independent scenarios described above. Therefore, the error matrix filter, after averaging the results by the number of samples N, is presented via the following error matrix indicated by Equation 3 as follows: $A = \left(\begin{matrix}- 1 & 0 & 1 & 0 \\ 0 & - 1 & 0 & 1 \\ - 1 & 1 & - 1 & 1 \\ 1 & 1 & 1 & 1\end{matrix}\right)$

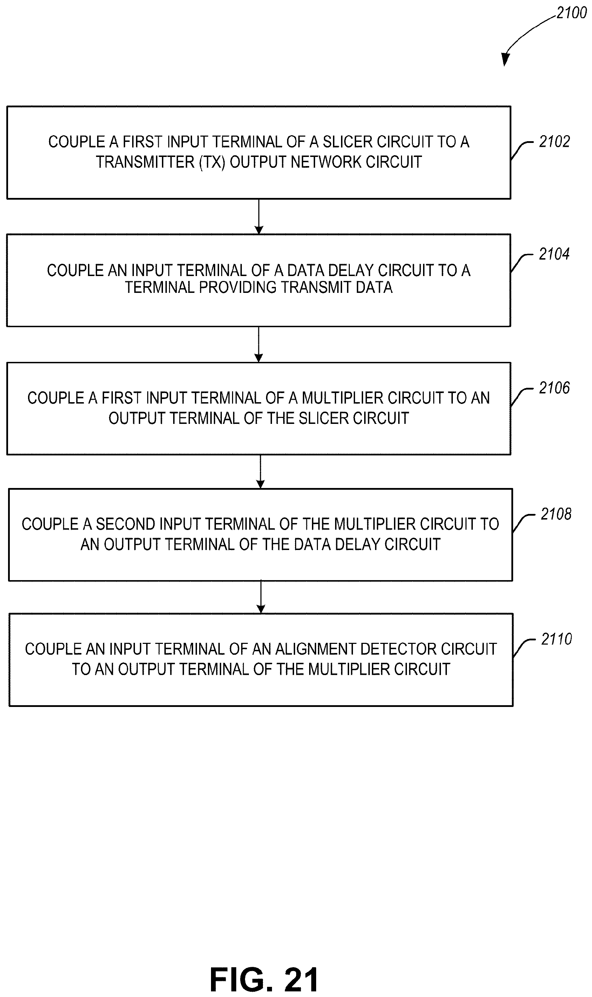

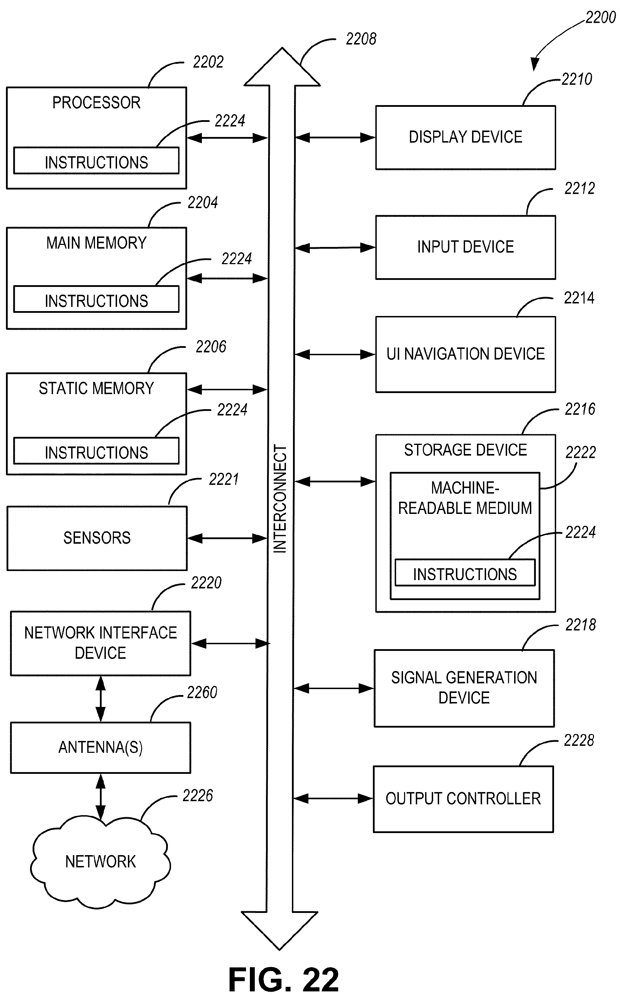

FIG. 21 is a flow diagram of an example process of making a phase error monitor, in accordance with some embodiments. Referring to FIG. 21, process 2100 includes operations 2102, 2104, 2106, 2108, and 2110, which may be executed by a processor, an embedded controller, a receiver circuit, a transceiver circuit, or another processor of a computing device (e.g., hardware processor 2202 of machine 2200 illustrated in FIG. 22, which can include one or more of the circuits discussed in connection with FIGS. 1-20). In some embodiments, one or more of the circuits described in connection with FIGS. 1-20 can perform the functionalities (or include the configurations or circuitry) associated with FIG. 21, as well as one or more of the examples listed below.

At operation 2102, a first input terminal of a slicer circuit 428 is coupled to a transmitter (Tx) output network circuit 424.

At operation 2104, an input terminal of a data delay circuit 430 is coupled to a terminal providing transmit data (e.g., an output terminal of the DSP 412.

At operation 2106, a first input terminal of a multiplier circuit 432 is coupled to an output terminal of the slicer circuit 428.

At operation 2108, a second input terminal of the multiplier circuit 432 is coupled to an output terminal of the data delay circuit 430.

At operation 2110, an input terminal of an alignment detector circuit 434 is coupled to an output terminal of the multiplier circuit 432.

FIG. 22 illustrates a block diagram of an example machine 2200 upon which any one or more of the techniques (e.g., methodologies) discussed herein may perform. In alternative embodiments, the machine 2200 may operate as a standalone device or may be connected (e.g., networked) to other machines. In a networked deployment, machine 2200 may operate in the capacity of a server machine, a client machine, or both in server-client network environments. In an example, machine 2200 may function as a peer machine in a peer-to-peer (P2P) (or other distributed) network environment. The machine 2200 may be a personal computer (PC), a tablet PC, a set-top box (STB), a personal digital assistant (PDA), a portable communications device, a mobile telephone, a smartphone, a web appliance, a network router, switch or bridge, or any other computing device capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations. The terms "machine," "computing device," and "computer system" are used interchangeably.

Machine (e.g., computer system) 2200 may include a hardware processor 2202 (e.g., a central processing unit (CPU), a graphics processing unit (GPU), a hardware processor core, or any combination thereof), a main memory 2204, and a static memory 2206, some or all of which may communicate with each other via an interlink (e.g., bus) 2208. In some aspects, the main memory 2204, the static memory 2206, or any other type of memory (including cache memory) used by machine 2200 can be configured based on the disclosed techniques or can implement the disclosed memory devices.

Specific examples of main memory 2204 include Random Access Memory (RAM) and semiconductor memory devices, which may include, in some embodiments, storage locations in semiconductors such as registers. Specific examples of static memory 2206 include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; RAM; and CD-ROM and DVD-ROM disks.

Machine 2200 may further include a display device 2210, an input device 2212 (e.g., a keyboard), and a user interface (UI) navigation device 2214 (e.g., a mouse). In an example, the display device 2210, the input device 2212, and the UI navigation device 2214 may be a touchscreen display. The machine 2200 may additionally include a storage device (e.g., drive unit or another mass storage device) 2216, a signal generation device 2218 (e.g., a speaker), a network interface device 2220, and one or more sensors 2221, such as a global positioning system (GPS) sensor, compass, accelerometer, or other sensors. The machine 2200 may include an output controller 2228, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.). In some embodiments, the hardware processor 2202 and/or instructions 2224 may comprise processing circuitry and/or transceiver circuitry.

The storage device 2216 may include a machine-readable medium 2222 on which one or more sets of data structures or instructions 2224 (e.g., software) embodying or utilized by any one or more of the techniques or functions described herein can be stored. Instructions 2224 may also reside, completely or at least partially, within the main memory 2204, within static memory 2206, or the hardware processor 2202 during execution thereof by machine 2200. In an example, one or any combination of the hardware processor 2202, the main memory 2204, the static memory 2206, or the storage device 2216 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

While the machine-readable medium 2222 is illustrated as a single medium, the term "machine-readable medium" may include a single medium or multiple media (e.g., a centralized or distributed database and/or associated caches and servers) configured to store instructions 2224.

An apparatus of machine 2200 may be one or more of a hardware processor 2202 (e.g., a central processing unit (CPU), a graphics processing unit (GPU), a hardware processor core, or any combination thereof), a main memory 2204 and a static memory 2206, one or more sensors 2221, a network interface device 2220, one or more antennas 2260, a display device 2210, an input device 2212, a UI navigation device 2214, a storage device 2216, instructions 2224, a signal generation device 2218, and an output controller 2228. The apparatus may be configured to perform one or more of the methods and/or operations disclosed herein. The apparatus may be intended as a component of machine 2200 to perform one or more of the methods and/or operations disclosed herein and/or to perform a portion of one or more of the methods and/or operations disclosed herein. In some embodiments, the apparatus may include a pin or other means to receive power. In some embodiments, the apparatus may include power conditioning hardware.

The term "machine-readable medium" may include any medium that is capable of storing, encoding, or carrying instructions for execution by machine 2200 and that causes machine 2200 to perform any one or more of the techniques of the present disclosure, or that is capable of storing, encoding, or carrying data structures used by or associated with such instructions. Non-limiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

The instructions 2224 may further be transmitted or received over a communications network 2226 using a transmission medium via the network interface device 2220 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi^{®}, IEEE 802.16 family of standards known as WiMax^{®}), IEEE 802.8.4 family of standards, a Long Term Evolution (LTE) family of standards, a Universal Mobile Telecommunications System (UMTS) family of standards, peer-to-peer (P2P) networks, among others.

In an example, the network interface device 2220 may include one or more physical jacks (e.g., Ethernet, coaxial, or phone jacks) or one or more antennas to connect to the communications network 2226. In an example, the network interface device 2220 may include one or more antennas 2260 to wirelessly communicate using at least one single-input multiple-output (SIMO), multiple-input multiple-output (MIMO), or multiple-input single-output (MISO) techniques. In some examples, the network interface device 2220 may wirelessly communicate using multiple-user MIMO techniques. The term "transmission medium" shall be taken to include any intangible medium that can store, encode, or carry instructions for execution by machine 2200 and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a particular manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part, all, or any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at separate times. The software may accordingly configure a hardware processor, for example, to constitute a particular module at one instance of time and to constitute a different module at a different instance of time.

Some embodiments may be implemented wholly or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM), random access memory (RAM), magnetic disk storage media, optical storage media, flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, examples that include the elements shown or described are also contemplated. Moreover, also contemplated are examples using any combination or permutation of those elements shown or described (or one or more aspects thereof), either with respect to a particular example (or one or more aspects thereof) or with respect to other examples (or one or more aspects thereof) shown or described herein.

Publications, patents, and patent documents referred to in this document are incorporated by reference herein in their entirety, as though individually incorporated by reference. In the event of inconsistent usage between this document and those documents so incorporated by reference, the usage in the incorporated reference(s) is supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc., are used merely as labels and are not intended to suggest a numerical order for their objects.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments, such as part of a system on chip, a set of intercommunicating functional blocks, or similar, although the scope of the disclosure is not limited in this respect.

Described implementations of the subject matter can include one or more features, alone or in combination, as illustrated below by way of examples.

Example 1 is an apparatus comprising a slicer circuit comprising a first input terminal coupled to a transmitter (Tx) output network circuit; a data delay circuit comprising an input terminal to receive transmit data; a multiplier circuit comprising a first input terminal coupled to an output terminal of the slicer circuit and a second input terminal coupled to an output terminal of the data delay circuit; and an alignment detector circuit comprising an input terminal coupled to an output terminal of the multiplier circuit.

In Example 2, the subject matter of Example 1 includes a pattern filter circuit comprising an input terminal coupled to an output terminal of the alignment detector circuit.

In Example 3, the subject matter of Example 2 includes an error filter accumulator circuit comprising at least one input terminal coupled to at least one output terminal of the pattern filter circuit.

In Example 4, the subject matter of Example 3 includes a signal correction circuit comprising an input terminal coupled to an output terminal of the error filter accumulator circuit.

In Example 5, the subject matter of Example 4 includes a delay line circuit comprising an output terminal coupled to a second input terminal of the slicer circuit.

In Example 6, the subject matter of Example 5 includes subject matter where an input terminal of the delay line circuit is coupled to an output terminal of the signal correction circuit.

In Example 7, the subject matter of Example 6 includes a phase error correction (PEC) circuit coupled to the output terminal of the signal correction circuit.

In Example 8, the subject matter of Example 7 includes a duty cycle corrector (DCC) circuit coupled to the PEC circuit and the output terminal of the signal correction circuit.

In Example 9, the subject matter of Examples 3-8 includes a multiplexer circuit coupled to the at least one output terminal of the pattern filter circuit and the at least one input terminal of the error filter accumulator circuit.

In Example 10, the subject matter of Example 9 includes a phase iterator circuit comprising an output terminal coupled to the multiplexer circuit.

In Example 11, the subject matter of Examples 1-10 includes subject matter where the alignment detector circuit further comprises: an XOR gate comprising an input terminal coupled to the output terminal of the slicer circuit.

In Example 12, the subject matter of Example 11 includes subject matter where the alignment detector circuit further comprises: a counter circuit coupled to the XOR gate.

In Example 13, the subject matter of Examples 8-12 includes a system-on-chip (SoC), the SoC comprising an integrated circuit (IC), the IC comprising at least one of the slicer circuit, the data delay circuit, the multiplier circuit, the alignment detector circuit, the pattern filter circuit, the error filter accumulator circuit, the signal correction circuit, the delay line circuit, the PEC circuit, or the DCC circuit.

In Example 14, the subject matter of Example 13 includes subject matter where the SoC further comprises at least one connector, and wherein the at least one connector conforms with at least one of a Universal Serial Bus (USB) specification, a High-Definition Multimedia Interface (HDMI) specification, a Thunderbolt specification, a Peripheral Component Interconnect Express (PCIe) specification, or an Ethernet specification.

Example 15 is an apparatus comprising a transmitter (Tx) circuit comprising a Tx output network circuit; and a slicer circuit comprising a first input terminal coupled to the Tx output network circuit; and a current symbol identification circuit comprising a data delay circuit comprising an input terminal to receive transmit data supplied to the Tx circuit; a multiplier circuit comprising a first input terminal coupled to an output terminal of the slicer circuit and a second input terminal coupled to an output terminal of the data delay circuit; and an alignment detector circuit comprising an input terminal coupled to an output terminal of the multiplier circuit.

In Example 16, the subject matter of Example 15 includes a data edge detection circuit comprising a pattern filter circuit comprising an input terminal coupled to an output terminal of the alignment detector circuit; and an error filter accumulator circuit comprising at least one input terminal coupled to at least one output terminal of the pattern filter circuit.

In Example 17, the subject matter of Example 16 includes a clock skew correction circuit comprising a signal correction circuit comprising an input terminal coupled to an output terminal of the error filter accumulator circuit.

In Example 18, the subject matter of Example 17 includes subject matter where the Tx circuit further comprises: a delay line circuit comprising an output terminal coupled to a second input terminal of the slicer circuit, wherein an input terminal of the delay line circuit is coupled to an output terminal of the signal correction circuit.

Example 19 is a process of making a phase error monitor, the process comprising coupling a first input terminal of a slicer circuit to a transmitter (Tx) output network circuit; coupling an input terminal of a data delay circuit to a terminal providing transmit data; coupling a first input terminal of a multiplier circuit to an output terminal of the slicer circuit; coupling a second input terminal of the multiplier circuit to an output terminal of the data delay circuit; and coupling an input terminal of an alignment detector circuit to an output terminal of the multiplier circuit.

In Example 20, the subject matter of Example 19 includes coupling an input terminal of a pattern filter circuit to an output terminal of the alignment detector circuit; coupling at least one input terminal of an error filter accumulator circuit to at least one output terminal of the pattern filter circuit; and coupling an input terminal of a signal correction circuit to an output terminal of the error filter accumulator circuit.

Example 21 is at least one machine-readable medium including instructions that, when executed by processing circuitry, cause the processing circuitry to perform operations to implement any of Examples 1-20.

Example 22 is an apparatus comprising means to implement any of Examples 1-20.

Example 23 is a system to implement any of Examples 1-20.

Example 24 is a method to implement any of Examples 1-20.

The above description is intended to be illustrative and not restrictive. For example, the above-described examples (or one or more aspects thereof) may be used in combination with others. Other embodiments may be used, such as by one of ordinary skill in the art upon reviewing the above description. The abstract is to allow the reader to ascertain the nature of the technical disclosure quickly. It is submitted with the understanding that it will not be used to interpret or limit the scope or meaning of the claims. Also, in the above Detailed Description, various features may be grouped to streamline the disclosure. However, the claims may not set forth every feature disclosed herein as embodiments may feature a subset of said features. Further, embodiments may include fewer features than those disclosed in a particular example. Thus, the following claims are hereby incorporated into the Detailed Description, with a claim standing on its own as a separate embodiment. The scope of the embodiments disclosed herein is to be determined regarding the appended claims, along with the full scope of equivalents to which such claims are entitled.

## Claims

1. An apparatus comprising:
a slicer circuit comprising a first input terminal coupled to a transmitter, Tx, output network circuit;
a data delay circuit comprising an input terminal to receive transmit data;
a multiplier circuit comprising a first input terminal coupled to an output terminal of the slicer circuit and a second input terminal coupled to an output terminal of the data delay circuit; and
an alignment detector circuit comprising an input terminal coupled to an output terminal of the multiplier circuit.

2. The apparatus of claim 1, further comprising:
a pattern filter circuit comprising an input terminal coupled to an output terminal of the alignment detector circuit;
an error filter accumulator circuit comprising at least one input terminal coupled to at least one output terminal of the pattern filter circuit; and
a signal correction circuit comprising an input terminal coupled to an output terminal of the error filter accumulator circuit.

3. The apparatus of claim 2, further comprising:
a delay line circuit comprising an output terminal coupled to a second input terminal of the slicer circuit, wherein an input terminal of the delay line circuit is coupled to an output terminal of the signal correction circuit.

4. The apparatus of claim 3, further comprising:
a phase error correction, PEC, circuit coupled to the output terminal of the signal correction circuit; and
a duty cycle corrector, DCC, circuit coupled to the PEC circuit and the output terminal of the signal correction circuit.

5. The apparatus of claim 2, further comprising:
a multiplexer circuit coupled to the at least one output terminal of the pattern filter circuit and the at least one input terminal of the error filter accumulator circuit; and
a phase iterator circuit comprising an output terminal coupled to the multiplexer circuit.

6. The apparatus of any of claims 1-5, wherein the alignment detector circuit further comprises:
an XOR gate comprising an input terminal coupled to the output terminal of the slicer circuit.

7. The apparatus of claim 6, wherein the alignment detector circuit further comprises:
a counter circuit coupled to the XOR gate.

8. The apparatus of claim 4, comprising:
a system-on-chip (SoC), the SoC comprising an integrated circuit (IC), the IC comprising at least one of the slicer circuit, the data delay circuit, the multiplier circuit, the alignment detector circuit, the pattern filter circuit, the error filter accumulator circuit, the signal correction circuit, the delay line circuit, the PEC circuit, or the DCC circuit.

9. The apparatus of claim 8, wherein the SoC further comprises at least one connector, and wherein the at least one connector conforms with at least one of a Universal Serial Bus (USB) specification, a High-Definition Multimedia Interface, HDMI, specification, a Thunderbolt specification, a Peripheral Component Interconnect Express, PCIe, specification, or an Ethernet specification.

10. A system comprising:
a transmitter, Tx, circuit comprising:
a Tx output network circuit;
a slicer circuit comprising a first input terminal coupled to the Tx output network circuit; and
a current symbol identification circuit comprising:
a data delay circuit comprising an input terminal to receive transmit data supplied to the Tx circuit;
a multiplier circuit comprising a first input terminal coupled to an output terminal of the slicer circuit and a second input terminal coupled to an output terminal of the data delay circuit; and
an alignment detector circuit comprising an input terminal coupled to an output terminal of the multiplier circuit.

11. The system of claim 10, further comprising:
a data edge detection circuit comprising:
a pattern filter circuit comprising an input terminal coupled to an output terminal of the alignment detector circuit; and
an error filter accumulator circuit comprising at least one input terminal coupled to at least one output terminal of the pattern filter circuit.

12. The system of claim 11, further comprising:
a clock skew correction circuit comprising:
a signal correction circuit comprising an input terminal coupled to an output terminal of the error filter accumulator circuit, wherein the Tx circuit further comprises:
a delay line circuit comprising an output terminal coupled to a second input terminal of the slicer circuit, wherein an input terminal of the delay line circuit is coupled to an output terminal of the signal correction circuit.

13. A process of making a phase error monitor, the process comprising:
coupling a first input terminal of a slicer circuit to a transmitter, Tx, output network circuit;
coupling an input terminal of a data delay circuit to a terminal providing transmit data;
coupling a first input terminal of a multiplier circuit to an output terminal of the slicer circuit;
coupling a second input terminal of the multiplier circuit to an output terminal of the data delay circuit; and
coupling an input terminal of an alignment detector circuit to an output terminal of the multiplier circuit.

14. The process of claim 13, further comprising:
coupling an input terminal of a pattern filter circuit to an output terminal of the alignment detector circuit;
coupling at least one input terminal of an error filter accumulator circuit to at least one output terminal of the pattern filter circuit; and
coupling an input terminal of a signal correction circuit to an output terminal of the error filter accumulator circuit.

15. A computer program comprising instructions which, when the program is executed by a computer, cause the computer to carry out one or more operations according to at least one of Claims 1 to 14.
